# EUROPÄISCHE PATENTSCHRIFT

(11) **EP 1 289 807 B1**
(45) Veröffentlichungstag und Bekanntmachung des Hinweises auf die Patenterteilung: **23.08.2006**
(21) Anmeldenummer: 01944921.4
(22) Anmeldetag: 09.05.2001
(51) Int. Cl.: B60S 1/38, C23C 16/02, C23C 16/455, C23C 16/458

(54) **VERFAHREN UND VORRICHTUNG ZUM BESCHICHTEN VON MINDESTENS EINEM WISCHGUMMI**
METHOD AND DEVICE FOR COATING AT LEAST ONE WIPER-BLADE ELEMENT
PROCEDE ET DISPOSITIF POUR ENDUIRE AU MOINS UNE LAME D'ESSUIE-GLACE

(30) Priorität: 24.05.2000 DE 10025689
(43) Veröffentlichungstag der Anmeldung: 12.03.2003
(73) Patentinhaber: ROBERT BOSCH GMBH, 70442 Stuttgart (DE)
(72) Erfinder: BURGER, Kurt, 71292 Friolzheim (DE); SCHNEIDER, Guenter, 74354 Besigheim (DE); BURGHOFF, Klaus, 70839 Gerlingen (DE); WEBER, Thomas, 70193 Stuttgart (DE); FORGET-FUNK, Jeanne, Mountain View, CA 94041 (US)
(86) Internationale Anmeldenummer: PCT/DE2001/001769
(87) Internationale Veröffentlichungsnummer: WO 2001/089893

(56) Entgegenhaltungen:
- EP-A- 0 821 077
- WO-A-99/51471

## Beschreibung

### Stand der Technik

Die Erfindung geht aus von einem Verfahren zum Beschichten von mindestens einem Wischgummi nach dem Oberbegriff des Anspruchs 1.

Wischgummis für Scheibenwischer von Fahrzeugen werden in sehr hoher Stückzahl gefertigt, typischerweise mehrere zehntausend Stück am Tag. Sie werden aus einem extrudierten und anschließend vulkanisierten Gummiband geschnitten.

Aus der DE 198 14 805 A1 ist ein Beschichtungsverfahren eines Wischgummis bekannt, bei dem auf einem extrudierten, elastomeren Material in einem CVD-Prozess (Chemical Vapor Deposition, chemisches Ablagerungsverfahren aus der Dampfphase) mindestens eine Schutzschicht an der Oberfläche des Wischgummis gebildet wird, um die Verschleiß- und Gleiteigenschaften des Wischgummis zu verbessern. Damit die Schutzschicht besser an dem Grundmaterial haftet, wird die Oberfläche des Wischgummis vorbehandelt, indem sie durch ein Plasma gereinigt und aktiviert wird. Außerdem kann eine Haftvermittlerschicht aufgetragen werden.

Ferner ist es bekannt, dass durch eine am Wischgummi angelegte Vorspannung die plasmagestützte Abscheidung der Schutzschicht zu dichteren und verschleißfesteren Schichten führt. Dabei wird der Wischgummi über eine Elektrode geführt, an der eine Vorspannung anliegt. Diese Vorspannung, auch Bias genannt, wird gegen Masse oder eine Gegenelektrode gepulst oder ungepulst geführt. Dabei werden Pulsfrequenzen zwischen 10 kHz und einigen MHz eingesetzt, bevorzugt 50 bis 250 kHz. Die Vorspannung kann aber auch von einer Frequenzquelle gespeist werden mit Frequenzen zwischen 1 kHz und 100 MHz, bevorzugt zwischen 50 kHz bis 27 MHz, insbesondere 13,56 MHz. Die Vorspannung beschleunigt Ionen aus dem Plasma in Richtung der Oberfläche des Wischgummis. Dort treffen diese auf die bereits abgeschiedene Schicht und führen zu einer Vernetzung und Verdichtung der Schicht. Vorteilhaft stellt sich die Vorspannung selbst ein und kann einen Wert zwischen wenigen Volt und 2 kV annehmen.

Um große Stückzahlen von Wischgummis behandeln und beschichten zu können, wird die Beschichtung vorzugsweise in einen kontinuierlichen Fertigungsfluß eingebunden, wodurch Raum, Zeit und Kosten eingespart werden können. Dabei eignen sich besonders Durchlaufkonzepte, bei denen die Wischgummis im Strang extrudiert und durch die differenziell gepumpte Vakuumkammer bzw. Reaktionskammer unter atmosphärischem Druck an den Beschichtungsquellen vorbeigeführt werden. Die Koppelung zweier kritischer Fertigungsschritte, nämlich des Extrudierens und Beschichtens des Wischgummis, führt allerdings bei einem Ausfall in einem Teil der Fertigungsanlage zu deren gesamten Stillstand und zu größeren Ausschussmengen. Ferner kann bei dem abschließenden Schneidvorgang die Schutzschicht an den Enden des Wischgummis beschädigt werden.

Aus der EP 0 821 077 A2 ist es bekannt, einzelne Teile, unter anderen auch Wischblätter für Kraftfahrzeuge, in einem CVD-Prozess mit einer kohlenstoffhaltigen Schicht zu versehen. Dazu wird das Objekt in einer Vakuumkammer auf eine Elektrode gelegt und einem Plasmagas ausgesetzt.

Ferner ist aus der EP 0 264 227 A2 ein Wischgummi für Scheibenwischer bekannt, der aus einem hoch molekularen Werkstoff besteht. Zu der Gruppe der Werkstoffe gehören u.a. Naturgummi, synthetischer Gummi, Elastomere, synthetische Kunststoffe und dgl. Die Oberfläche des Wischgummis erhält eine polymere Schutzschicht, die direkt aus einem monomeren Gas gebildet wird, indem Plasmaenergie genutzt wird.

### Vorteile der Erfindung

Nach der Erfindung wird das Material vor dem Einbringen in eine Behandlungskammer aus einem Profilband auf eine gebrauchsfertige Länge zu einzelnen Wischgummis geschnitten, auf der Elektrodenplatte angeordnet und einem Plasmastrom ausgesetzt.

Die einzelnen Behandlungsschritte werden in vorteilhafter Weise nacheinander in einer Behandlungskammer in einem so genannten Einkammer-Batch-Prozess oder bei großen Stückzahlen in einem Mehrkammer-Batch-Prozess mit mehreren Behandlungskammern durchgeführt. Zweckmäßigerweise wird in jeder Kammer ein einzelner Behandlungsschritt vorgenommen, wobei Taktzeiten zwischen den einzelnen Behandlungsschritten zwischen 10 Sekunden und einigen Minuten liegen können. Taktzeiten zwischen 30 Sekunden und 1 Minute haben sich besonders bewährt. Durch den Batch-Prozess werden die fertigungstechnisch kritischen Prozesse der Gummiformgebung und der Beschichtung entkoppelt. Treten in dem einen Fertigungsprozess Störungen auf, wird der andere Fertigungsprozess dadurch nicht beeinflusst. Dadurch wird außerdem das Ausschussrisiko verringert. Im Gegensatz zu Durchlaufanlagen ist eine Beschichtungsanlage mit mehreren Behandlungskammern kostengünstiger und flexibler zu gestalten, da je nach Behandlungsdauer mehrere gleichartige Behandlungskammern parallel gefahren werden können. Dies wirkt sich besonders günstig aus, wenn die Vorbehandlung bei einem geringen Vakuum von ungefähr 0,1 bis 100 mbar stattfindet.

Die Wischgummis können zweckmäßigerweise aus einem extrudierten Doppelstrangprofil geschnitten werden, bei dem die Wischlippen einander zugewandt und über einen Steg miteinander verbunden sind. Eine Seite der Wischlippen liegt an der Elektrodenplatte an. Nach der Beschichtung der ersten Seite muss der Wischgummi innerhalb oder außerhalb der Behandlungskammer gewendet werden. Ist die Beschichtung vollständig abgeschlossen, werden die Wischlippen von Steg abgetrennt. Es ist auch möglich, die Wischlippen vor der Beschichtung auseinander zu schneiden.

Bei einer Variante der Erfindung sind die Wischgummis so angeordnet, dass die Wischlippen etwa senkrecht zur Elektrodenplatte stehen, die sich zu beiden Seiten des Wischgummis erstreckt. So können beide Seiten der Wischlippe des Wischgummis gleichzeitig behandelt und beschichtet werden. Mehrere Wischgummis können auf einer Elektrodenplatte, die ein Teil eines Warenträgers darstellt, nebeneinander und in Reihe angeordnet werden. Sie können unterschiedliche Längen und Profile aufweisen.

Die Elektrodenplatte greift zweckmäßigerweise seitlich in Längsnuten des Wischgummis, die für Krallenbügel oder Federschienen vorgesehen sind, so dass die Wischgummis sicher auf der Elektrodenplatte fixiert sind. Somit ist eine flexible Fertigung für große Stückzahlen möglich. Ferner können Trenn- oder Schneidprozesse nach dem Beschichten entfallen, durch die die Schutzschicht beschädigt werden könnte.

An der Elektrodenplatte liegt zweckmäßigerweise eine Wechselspannung mit einer Frequenz von 10 kHz bis zu einigen MHz, vorzugsweise 13,56 MHz, an, wobei die einzukoppelnde Leistung ungefähr 1 bis 100 W/cm² Elektrodenfläche beträgt. Abhängig von der eingekoppelten Leistung, vom Gesamtdruck und von den Flächenverhältnissen zwischen Elektrodenplatte und Masse bildet sich im Plasma ein negatives Potenzial (Self-Bias). Dieses Potenzial greift durch das Gummi des Wischgummis durch und beschleunigt die sich im Plasma befindenden Ionen zur Gummioberfläche hin. Dieses Ionenbombardement bewirkt eine Kompaktierung der Schicht und so eine Erhöhung der Schichthärte. Die Effektivität des Ionenbeschusses ist von der Dicke des auf der Elektrodenplatte liegenden Dielektrikums, des Elastomermaterials abhängig.

Durch einen größeren Abstand zwischen Elektrode und Gummioberfläche ist das von der Self-Bias-Spannung an der Oberfläche induzierte Potenzial geringer. Durch die erfindungsgemäße Anordnung des Wischgummis auf der Elektrodenplatte variieren durch den unterschiedlichen Abstand der Wischlippe und des Befestigungsteils von der Elektrodenplatte der Ionenbeschuss und die sich daraus ergebende Schichthärte. Es kann so ein Härte- und Schichtdickengradient entstehen, der von einer weicheren Schicht an der Wischlippe bis zu einer härteren Schicht am Profilrücken reicht. Für die Funktionalität des Wischgummis ist aber die Dicke und Härte der Schutzschicht direkt an der Wischlippe maßgebend. Die Schichtdicke und Schichthärte, die sich am Befestigungsteil einstellt, beeinflusst nur unwesentlich den Wischvorgang. Da das sich an der Elektrodenplatte einstellende Potenzial bis zu beiden Seiten der Wischlippe reicht, können in vorteilhafter Weise beide Seiten der Wischlippe gleichzeitig beschichtet werden.
Um das sich einstellende negative Potenzial zu beeinflussen und in Bezug auf die jeweilige Sorte und den Typ des Wischgummis zu optimieren, wird gemäß einer Ausgestaltung der Erfindung vorgeschlagen, die Elektrodenplatte vollständig oder partiell mit isolierendem Material abzudecken. So kann die mit dem Plasma in Kontakt stehende Fläche modifiziert werden und die sich an der Elektrodenplatte einstellende Self-Bias-Spannung eingestellt werden.

Das Gas wird über Gasdüsen in die Behandlungskammern eingeleitet, wobei Öffnungen der Düsen den Wischlippen der eingebrachten Wischgummis zugewandt sind. Als Beschichtungsmaterial eignen sich niedrigmolekulare, vernetzbare gasförmige Stoffe, halogen-, silizium-, kohlenstoffhaltige oder metallorganische Monomere. Eine oder mehrere Gasdüsen können einem oder mehreren Wischgummis zugeordnet sein, um eine gleichmäßige Beschichtung einer Charge zu gewährleisten. In den Behandlungskammern werden Leitvorrichtungen für das Gas vorgesehen. Diese bestehen darin, dass an den Längsseiten der Wischgummis seitlich der Elektrodenplatten Gasschlitze angeordnet sind, durch die das Gas von einer Vakuumpumpe abgesaugt wird. Zusätzlich können in der Behandlungskammer weitere Gasleitbleche angeordnet sein.

Wenn mehrere Behandlungskammern vorgesehen sind, können diese in einer Linie angeordnet und durch Transportmittel miteinander verkettet sein. Je nach Raumverhältnissen kann es vorteilhaft sein, mehrere Behandlungskammern in einer geschlossenen Konfiguration anzuordnen. Dabei ist es möglich, eine Behandlungskammer zum Ein- und Ausschleusen der Warenträger mit den Wischgummis zu nutzen.

### Zeichnung

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: einen Querschnitt durch ein Wischgummi,
- Fig. 2: einen schematischen Querschnitt durch eine Behandlungskammer,
- Fig. 3: eine lineare Anordnung von zwei Behandlungskammern und
- Fig. 4: einen Warenträger mit verschiedenen Wischgummis bestückt.
- Fig. 5: eine Anordnung von vier Behandlungskammern in einer geschlossenen Konfiguration.

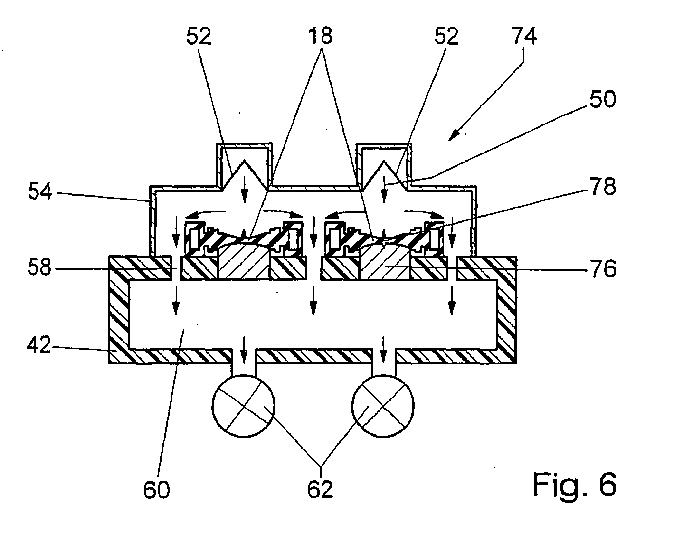

- Fig. 6: eine Variante zu Fig. 2.

### Beschreibung der Ausführungsbeispiele

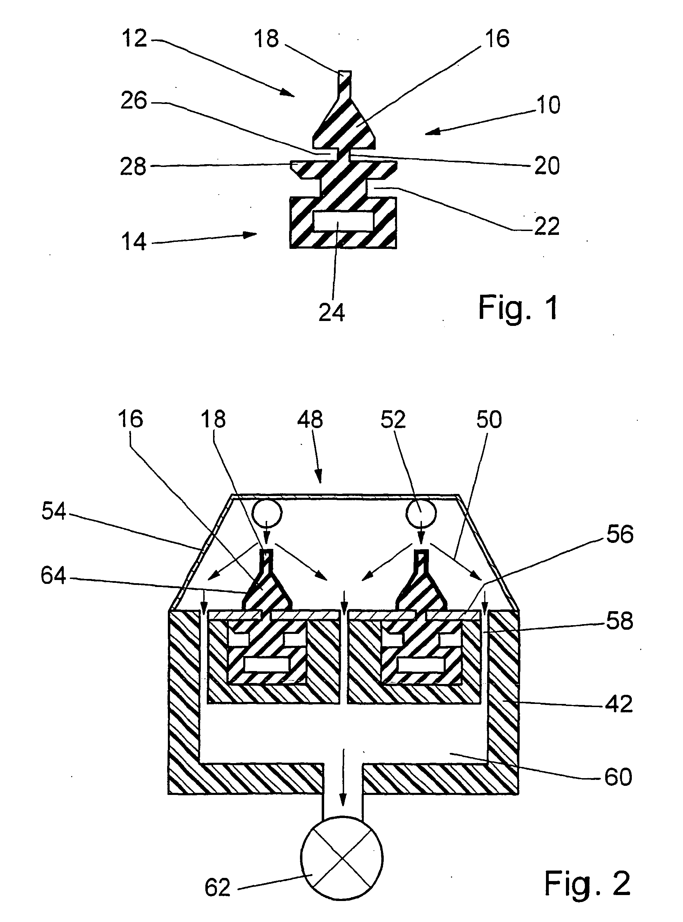

Der Wischgummi 10 nach Fig. 1 besitzt einen Profilrücken 14 und einen Funktionsteil 12 mit einem Wischkeil 16 und einer daran angeformten Wischlippe 18. Ein Kippsteg 20 verbindet den Funktionsteil 12 mit dem Profilrücken 14 und gestattet der Wischlippe 18 in den Umkehrlagen des Scheibenwischers umzukippen, so dass die Wischlippe 18 in Wischrichtung mit der Fahrzeugscheibe einen spitzen Winkel einschließt. Zu beiden Seiten des Kippstegs 20 werden zwischen dem Wischkeil 16 und einem Deckstreifen 28 des Profilrückens 14 Längsnuten 26 gebildet. Bei der Kippbewegung legt sich jeweils eine Schulter des Wischkeils 16 an dem Deckstreifen 28 an und begrenzt somit die Kippbewegung. Ferner verlaufen zu beiden Seiten des Profilrückens 14 Krallennuten 22, in die nicht näher dargestellte Krallen eines Krallenbügels des Scheibenwischers eingreifen. Der Profilrücken 14 weist schließlich einen Längskanal 24 auf, in den zur Versteifung des Wischgummis 10 eine nicht näher dargestellte Federschiene eingelegt wird.

Um die Gleit- und Verschleißeigenschaft des Wischgummis 10, insbesondere der Wischlippe 18 und des Wischkeils 16, zu verbessern, wird auf die Oberfläche des Wischgummis 10 eine Schutzschicht 64 aufgetragen, vorzugsweise in einem PECVD-Verfahren (Plasma-Enhanced-Chemical-Vapor-Deposition). Als Beschichtungsmaterial, das durch ein Plasma aktiviert wird, sind niedrig molekulare, vernetzbare gasförmige Stoffe, halogen-, silizium-, kohlenstoffhaltige oder metallorganische Monomere geeignet.

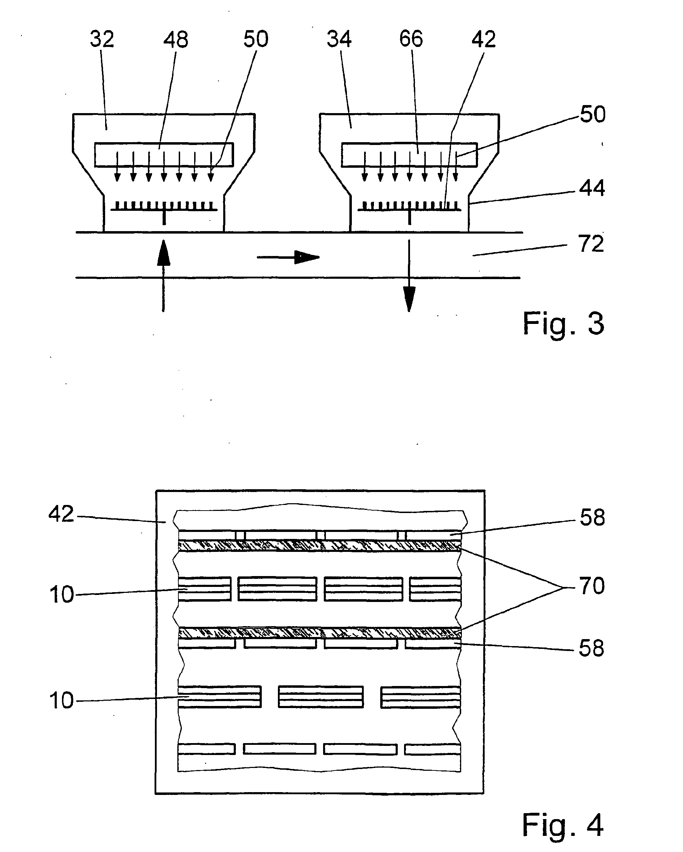

Vor der Beschichtung des Wischgummis 10 wird dieses aus einem extrudierten Profilstrang auf eine gebrauchsfertige Länge geschnitten und in einen Warenträger 42 eingesetzt (Fig. 2). Dabei können mehrere Wischgummis 10 auch mit unterschiedlicher Länge und einem unterschiedlichen Profil in Reihe hintereinander und in parallelen Reihen zueinander angeordnet werden (Fig. 4). Die Wischgummis 10 werden so in den Warenträger 42 eingesetzt, dass ihre Wischlippen 18 etwa senkrecht zu Elektrodenplatten 56 stehen, die zweckmäßigerweise seitlich in die Längsnuten 26 oder Krallennuten 22 eingreifen. Gegenüber den Wischlippen 18 sind Gasdüsen 52 vorgesehen, aus deren Öffnungen Gasstrahlen 50 des gasförmigen Beschichtungsmaterials ausströmen. Das Gas kann gezielt auf die Wischlippen 18 gerichtet sein oder diffus die Wischlippen 18 umströmen. Dabei kann das aus den Gasdüsen 52 ausströmende Gas zusätzlich durch Gasschlitze 58 und eventuell durch Gasleitbleche 54 zwischen den Wischgummis 10 geleitet und von einer Gaspumpe 62 aus einem Sammelraum 60 abgesaugt werden, der auf der den Gasdüsen 52 abgewandten Seite der Wischgummis 10 liegt. Zweckmäßigerweise werden die Gasdüsen 52 in Gasrahmen 48 zusammengefasst, wobei eine oder mehrere Gasdüsen 52 einer oder mehreren Wischlippen 18 zugeordnet sind. Bei dem erfindungsgemäßen Verfahren werden in vorteilhafter Weise beide Seiten der Wischlippen gleichzeitig behandelt und beschichtet.

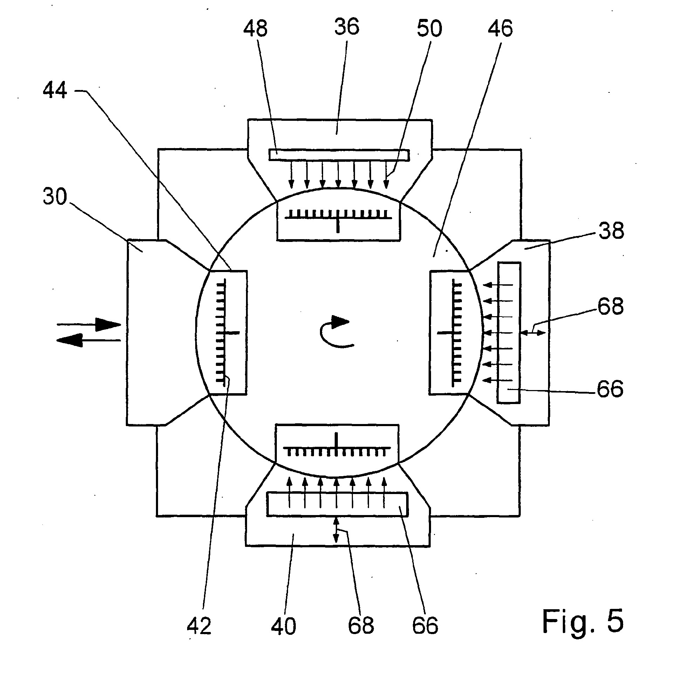

Der Beschichtungsprozess findet in einer Behandlungskammer 32, 34 (Fig. 3) bzw. in einer Behandlungskammer 38 oder 40 (Fig. 5) statt, und zwar in Druckbereichen von 10⁻² bis 100 mbar. Durch das direkte Einströmen der schichtbildenden Gase in ein mit Hochfrequenz gezündetes Plasma werden zehn- bis dreißigfach höhere Abscheideraten gegenüber üblichen Beschichtungsverfahren erreicht. Während der Beschichtung wird an der Elektrodenplatten eine hochfrequente Wechselspannung im Frequenzbereich von 10 kHz bis zu einigen MHz, vorzugsweise aber 13,56 MHz, angelegt. Die einzukoppelnde Leistung hängt von der Elektrodenfläche ab und beträgt ca. 1 bis 100 W/cm². Wird in der Behandlungskammer 32, 34, 38, 40 der Druck in einen Bereich von 100 mbar bis 10⁻² mbar abgesenkt, brennt an der Elektrodenplatte 56 und um die Wischlippe 18 das Plasma. Dieses bildet an der Elektrodenplatte 56 in Abhängigkeit von der eingekoppelten Leistung, vom Gesamtdruck, von den Flächenverhältnissen zwischen der Elektrodenplatte 56 und der Masse ein negatives Potenzial (Self-Bias). Die Fläche der Elektrodenplatte 56 kann modifiziert werden, indem sie teilweise oder ganz mit einem Isoliermaterial 70 abgedeckt wird.

Das negative Potenzial greift durch das Gummi des Wischgummis 10 und bewirkt eine Beschleunigung der sich im Plasma befindenden Ionen auf die Gummioberfläche. Dieses Ionenbombardement bewirkt eine Kompaktierung der Schutzschicht 64 und erhöht somit die Schichthärte. Die Effektivität des Ionenbeschusses ist von der Dicke des auf der Elektrodenplatte 56 liegenden Dielektrikums, hier das Elastomermaterial des Wischgummis 10, abhängig. Mit einem größeren Abstand zwischen der Elektrodenplatte 56 und der Gummioberfläche wird das von der Self-Bias-Spannung an der Oberfläche induzierte Potenzial geringer. Somit variiert zwischen der Wischlippe 18 und dem Profilrücken 14 der Ionenbeschuss und daraus folgend die Schichthärte. Die Härte der Schutzschicht 64 nimmt entsprechend dem Härte- und Schichtgradienten von der Wischlippe 18 zum Profilrücken 14 hin zu. Wichtig für die Funktionalität des Wischgummis 10 ist die Dicke und Härte der Schutzschicht 64 an der Wischlippe 18. Die Schichtdicke der Schutzschicht 64 und die Schichthärte, die sich am Profilrücken 14 einstellen, beeinflussen nur unwesentlich den Wischvorgang. Um ein besseres Wischbild zu erhalten, kann es vorteilhaft sein, die Wischlippe 18 erst nach der Beschichtung zu schneiden bzw. noch zu beschneiden.

Damit die Schutzschicht 64 sich besser mit dem Grundmaterial des Wischgummis 10 verbindet, ist es zweckmäßig, die Oberfläche des Wischgummis vorher mit einem plasmagestützten Verfahren zu reinigen und zu aktivieren. Dies findet in einem Vorbehandlungsprozess bei einem Druck von ungefähr 0,1 bis 100 mbar statt. Ferner kann auf den Wischgummi 10 eine dünne Haftvermittlerschicht aufgebracht werden.

Grundsätzlich können die verschiedenen Behandlungsschritte in einer Behandlungskammer 32, 34, 36, 38, 40 nacheinander durchgeführt werden, zweckmäßigerweise werden die Behandlungsschritte jedoch in verschiedenen Behandlungskammern 32, 34, 36, 38, 40 durchgeführt, wobei die Wischgummis 10 mit ihrem Warenträger 42 und einem Transportgehäuse 44 mittels einer Fördervorrichtung, z.B. einem Kreisförderer 46, von einer Behandlungskammer 32 zur nächsten Behandlungskammer 34 gefördert werden. Bei einer Anlage nach Fig. 3 sind zwei Behandlungskammern 32 und 34 mittels einer Linearförderer 72 verkettet. Dabei kann die Behandlungskammer 32 gleichzeitig zum Beladen mit einem Warenträger 42 dienen, während die Behandlungskammer 34 gleichzeitig als Entladestation vorgesehen ist. Ferner kann in der Behandlungskammer 32 die Vorbehandlung stattfinden, während in der Behandlungskammer 34 das eigentliche Beschichtungsverfahren durchgeführt wird.

Bei der Anlage nach Fig. 5 ist eine Be- und Entladekammer 30 mit drei Behandlungskammern 36, 38 und 40 in einem Kreis angeordnet und durch einen Kreisförderer 46 miteinander verkettet. In die Belade- und Entladekammer 30 werden die Warenträger 42 bei Atmosphärendruck in die Anlage eingebracht und aus der Anlage entnommen. Während in der Behandlungskammer 36 die Vorbehandlung der Wischgummis 10 stattfindet, sind für die Beschichtung der Wischgummis 10 anschließend zwei Behandlungskammern 38 und 40 vorgesehen. Die Anzahl der Behandlungskammern 38, 40 kann je nach Dauer der gesamten Beschichtung und/oder der gewünschten Taktzeit variieren. Um die Schichtdicke auf den Wischgummis 10 modifizieren zu können, ist der Gasrahmen 66 in Richtung des Pfeils 68 in den Behandlungskammern 38 und 40 verfahrbar, so dass der Abstand der Gasdüsen 52 zu den Wischlippen 18 variabel ist.

Bei einer Variante nach Fig. 5 ist der Wischgummi 10 liegend angeordnet, wobei eine Seite der Wischlippe 18 an einer Elektrodenplatte 76 anliegt. Die plasmafizierten Gasstrahlen 50 sind auf die Wischlippe 18 gerichtet und werden von den Gasleitblechen 54 durch die Gasschlitze 58 in den Sammelraum 60 geleitet. Gaspumpen 62 saugen das überschüssige Gas ab und erzeugen einen gewünschten Unterdruck. Nachdem die erste Seite der Wischlippe 10 beschichtet ist, wird der Wischgummi innerhalb oder außerhalb der Behandlungskammer 74 gewendet.

Die Wischlippen 10 werden zweckmäßigerweise in einem Doppelstrang extrudiert, wobei die Wischlippen 18 über einen Steg 78 miteinander verbunden sind. Die Wischlippen 18 können vor oder nach der Beschichtung getrennt werden, indem sie längs des Stegs 78 abgeschnitten werden. Auf dem Warenträger 42 können mehrere Reihen unterschiedlicher Wischgummis 10 angeordnet werden.

## Patentansprüche

1. Verfahren zum Beschichten von Wischgummi (10) aus einem elastomeren Material, bei dem zunächst die Oberfläche des elastomeren Materials (10) durch ein Plasma gereinigt und aktiviert wird und bei dem dann in einem CVD-Prozess ein Beschichtungsmaterial in einen plasmaförmigen Zustand versetzt wird und mindestens eine Schutzschicht (64) auf der Oberfläche des Materials (10) bildet, wobei an dem der Schutzschicht (64) abgewandten Bereich des Materials (10) über eine Elektrode (56) eine hochfrequente Spannung anliegt, **dadurch gekennzeichnet, dass** das Material (10) vor dem Einbringen in eine Behandlungskammer (32, 34, 36, 38, 40, 74) aus einem Profilband auf eine gebrauchsfertige Länge (66) zu einzelnen Wischgummis geschnitten, auf einer Elektrodenplatte (56) eines Warenträgers (42) angeordnet und einem Plasmastrom (50) ausgesetzt wird.

2. Verfahren nach Anspruch 1, **dadurch gekennzeichnet, dass** die Behandlungsschritte in einem Einkammer- oder Mehrkammer-Batchprozess mit Taktzeiten zwischen zehn Sekunden und einigen Minuten durchgeführt werden.

3. Verfahren nach Anspruch 2, **dadurch gekennzeichnet, dass** die Taktzeiten zwischen dreißig Sekunden und einer Minute liegen.

4. Verfahren nach einem der vorhergehenden Ansprüche, **dadurch gekennzeichnet, dass** die Vorbehandlung bei einem Druck von ungefähr 0,1 bis 100 mbar stattfindet.

5. Verfahren nach einem der vorhergehenden Ansprüche, **dadurch gekennzeichnet, dass** auf den Wischgummi (10) eine dünne Haftvermittlerschicht aufgebracht wird.

6. Verfahren nach einem der vorhergehenden Ansprüche, **dadurch gekennzeichnet, dass** das Beschichtungsmaterial, das durch ein Plasma aktiviert wird, niedrigmolekulare, vernetzbare gasförmige Stoffe, halogen-, silizium-, kohlenstoffhaltige oder metallorganische Monomere sind.

7. Verfahren nach Anspruch 6, **dadurch gekennzeichnet, dass** die Wechselspannung, die an der Elektrodenplatte (56) anliegt, eine Frequenz von zehn kHz bis zu einigen MHz, vorzugsweise 13,56 MHz, hat und die einzukoppelnde Leistung ungefähr ein bis hundert Watt pro ein cm² Elektrodenfläche beträgt.

8. Verfahren nach einem der vorhergehenden Ansprüche, **dadurch gekennzeichnet, dass** der Wischgummi (10) mit einer Seite der Wischlippe (18) an einer Elektrodenplatte (76) anliegt.

9. Verfahren nach Anspruch 8, **dadurch gekennzeichnet, dass** zwei Wischgummis (10) mit einander zugewandten Wischlippen (18) an der Elektrodenplatte (76) anliegen.

10. Verfahren nach Anspruch 9, **dadurch gekennzeichnet, dass** zwei Wischgummis (10) mit einander zugewandten Wischlippen (18) an den Wischlippen über einen Steg (78) verbunden sind und nach der Beschichtung getrennt werden.

11. Verfahren nach einem der Ansprüche 1 bis 7, **dadurch gekennzeichnet, dass** die Wischlippe (18) des Wischgummis (10) etwa senkrecht zur Elektrodenplatte (56) steht, die sich zu beiden Seiten des Wischgummis (10) erstreckt.

12. Verfahren nach Anspruch 11, **dadurch gekennzeichnet, dass** die Elektrodenplatte (56) seitlich in Längsnuten (22, 26) des Wischgummis (10) eingreift.

13. Verfahren nach einem der vorhergehenden Ansprüche, **dadurch gekennzeichnet, dass** die Behandlungsschritte in verschiedenen Behandlungskammern (32, 34, 36, 38, 40) sequenziell durchgeführt werden.

14. Vorrichtung mit Wischgummi zum Durchführen des Verfahrens nach einem der vorhergehenden Ansprüche, **dadurch gekennzeichnet, dass** Behandlungskammern (32, 34, 36, 38, 40) Gasdüsen (52) aufweisen, deren Öffnungen den Wischlippen (18) der eingebrachten Wischgummis (10) zugewandt sind wobei, einer oder mehreren Gasdüsen (52) ein oder mehrere Wischgummis (10) zugeordnet sind, die aus einem Profilband auf eine gebrauchsfertige Läge (66) zu einzelnen Wischgummis geschnitten, auf einer Elektrodenplatte (56) eines Warenträgers (42) angeordnet sind, und an den Längsseiten der Wischgummis (10) seitlich der Elektrodenplatten (56, 76) Gasschlitze (58) angeordnet sind, durch die das Gas von einer Gaspumpe (62) abgesaugt wird.

15. Vorrichtung nach Anspruch 14 , **dadurch gekennzeichnet, dass** in der Behandlungskammer (34, 36, 38, 40, 74) Gasleitbleche (54) angeordnet sind.

16. Vorrichtung nach einem der Ansprüche 14 bis 15, **dadurch gekennzeichnet, dass** die Elektrodenplatte (56, 76) zumindest teilweise durch Isoliermaterial (70) abgedeckt ist.

17. Vorrichtung nach einem der Ansprüche 14 bis 18, **dadurch gekennzeichnet, dass** die Elektrodenplatte (56, 76) zur Aufnahme mehrerer Wischgummis (10) eingerichtet ist.

18. Vorrichtung nach einem der Ansprüche 14 bis 17, **dadurch gekennzeichnet, dass** mehrere Behandlungskammern (32, 34) in einer Linie angeordnet sind.

19. Vorrichtung nach einem der Ansprüche 14 bis 18, **dadurch gekennzeichnet, dass** mehrere Behandlungskammern (36, 38, 40) in einer geschlossenen Konfiguration angeordnet sind.

20. Vorrichtung nach einem der Ansprüche 14 bis 19, **dadurch gekennzeichnet, dass** die Wischgummis (10) und die Elektrodenplatten (56) auf einem Warenträger (42) angeordnet sind, der auf einem Transportmittel (46) befestigt wird, um die Wischgummis (10) von einer Behandlungskammer (36, 38, 40,74) zur andern zu befördern.

21. Vorrichtung nach Anspruch 20, **dadurch gekennzeichnet, dass** mindestens eine Behandlungskammer (32, 34) auch zum Beladen und/oder Entladen mit Warenträgern (42) dient.

## Claims

1. Method for coating a wiper blade element (10) made of an elastomeric material, in which firstly the surface of the elastomeric material (10) is cleaned and activated by a plasma and in which then, in a CVD process, a coating material is brought into a plasma state and at least one protective layer (64) forms on the surface of the material (10), a highfrequency voltage being applied by means of an electrode (56) to the region of the material (10) that is facing away from the protective layer (64), **characterized in that**, before being introduced into a treatment chamber (32, 34, 36, 38, 40, 74), the material (10) is cut from a profiled band to a ready-to-use length (66) to form individual wiper blade elements, arranged on an electrode plate (56) of a product carrier (42) and subjected to a plasma stream (50).

2. Method according to Claim 1, **characterized in that** the treatment steps are carried out in a single-chamber or multi-chamber batch process with cycle times of between ten seconds and several minutes.

3. Method according to Claim 2, **characterized in that** the cycle times are between thirty seconds and one minute.

4. Method according to one of the preceding claims, **characterized in that** the pretreatment takes place at a pressure of approximately 0.1 to 100 mbar.

5. Method according to one of the preceding claims, **characterized in that** a thin layer of bonding agent is applied to the wiper blade element (10).

6. Method according to one of the preceding claims, **characterized in that** the coating material which is activated by a plasma comprises low-molecular-weight, crosslinkable gaseous substances, halogen-containing, silicon-containing, carbon-containing or organo-metallic monomers.

7. Method according to Claim 6, **characterized in that** the alternating voltage which is applied to the electrode plate (56) has a frequency of ten kHz to several MHz, preferably 13.56 MHz, and the power to be coupled in has approximately one to one hundred watts per cm² of electrode surface area.

8. Method according to one of the preceding claims, **characterized in that** the wiper blade element (10) lies with one side of the wiper lip (18) against an electrode plate (76).

9. Method according to Claim 8, **characterized in that** two wiper blade elements (10) lie against the electrode plate (76) with the wiper lips (18) facing each other.

10. Method according to Claim 9, **characterized in that** two wiper blade elements (10) are connected, with the wiper lips (18) facing each other, at the wiper lips by means of a cross-piece (78), and are separated after coating.

11. Method according to one of Claims 1 to 7, **characterized in that** the wiper lip (18) of the wiper blade element (10) is approximately perpendicular to the electrode plate (56), which extends on both sides of the wiper blade element (10).

12. Method according to Claim 11, **characterized in that** the electrode plate (56) engages laterally in longitudinal grooves (22, 26) of the wiper blade element (10).

13. Method according to one of the preceding claims, **characterized in that** the treatment steps are carried out sequentially in various treatment chambers (32, 34, 36, 38, 40).

14. Device for carrying out the method according to one of the preceding claims, **characterized in that** treatment chambers (32, 34, 36, 38, 40) have gas nozzles (52), the openings of which face the wiper lips (18) of the inserted wiper blade elements (10), one or more gas nozzles (52) being assigned one or more wiper blade elements (10), which are cut from a profiled band to a ready-to-use length (66) to form individual wiper blade elements and arranged on an electrode plate (56) of a product carrier (42), and gas slots (58) through which the gas is evacuated by a gas pump (62) are arranged on the longitudinal sides of the wiper blade elements (10), lateral to the electrode plates (56, 76).

15. Device according to Claim 14, **characterized in that** gas baffles (54) are arranged in the treatment chamber (34, 36, 38, 40, 74).

16. Device according to either of Claims 14 and 15, **characterized in that** the electrode plate (56, 76) is at least partially covered by insulating material (70).

17. Device according to one of Claims 14 to 18, **characterized in that** the electrode plate (56, 76) is set up for receiving a number of wiper blade elements (10).

18. Device according to one of Claims 14 to 17, **characterized in that** a number of treatment chambers (32, 34) are arranged in a line.

19. Device according to one of Claims 14 to 18, **characterized in that** a number of treatment chambers (36, 38, 40) are arranged in a closed configuration.

20. Device according to one of Claims 14 to 19, **characterized in that** the wiper blade elements (10) and the electrode plates (56) are arranged on a product carrier (42), which is fastened on a transporting means (46), in order to transport the wiper blade elements (10) from one treatment chamber (36, 38, 40, 74) to the other.

21. Device according to Claim 20, **characterized in that** at least one treatment chamber (32, 34) also serves for the loading and/or unloading of product carriers (42).

## Revendications

1. Procédé de revêtement de lame d'essuyage (10) en élastomère selon lequel on nettoie et on active tout d'abord la surface de l'élastomère (10) avec un plasma et ensuite par un procédé CVD, on met une matière de revêtement à l'état de plasma et on forme au moins une couche protectrice (64) à la surface de la matière (10), en appliquant à la zone de la matière (10) opposée de la couche protectrice (64), une tension haute fréquence par l'intermédiaire d'une électrode (56),
**caractérisé en ce qu'**
avant d'introduire la matière (10) dans une chambre de traitement (32, 34, 36, 38, 40, 74) on la coupe d'un ruban profilé, à la longueur d'utilisation (66) pour former des lames d'essuyage, on l'installe sur une plaque d'électrode (56) d'un support de pièces (42) et on l'expose à un courant de plasma (50).

2. Procédé selon la revendication 1,
**caractérisé en ce qu'**
on effectue les étapes de traitement selon un procédé par lots avec une ou plusieurs chambres, et des temps de cadence compris entre dix secondes et quelques minutes.

3. Procédé selon la revendication 2,
**caractérisé en ce que**
les temps de cadence sont compris entre 30 secondes et 1 minute.

4. Procédé selon l'une des revendications précédentes,
**caractérisé en ce que**
le traitement préalable se fait à une pression d'environ 0,1 jusqu'à 100 mbars.

5. Procédé selon l'une des revendications précédentes,
**caractérisé en ce qu'**
on applique une mince couche d'agent d'accrochage sur la lame d'essuyage (10).

6. Procédé selon l'une des revendications précédentes,
**caractérisé en ce que**
la matière de revêtement activée par un plasma correspond à des matières gazeuses, réticulables, à faible poids moléculaire, des matières contenant des halogènes, du silicium et du carbone ou des monomères métalo-organiques.

7. Procédé selon la revendication 6,
**caractérisé en ce que**
la tension alternative appliquée à la plaque d'électrode (56) a une fréquence de 10 kHz jusqu'à quelques MHz, de préférence 13,56 MHz et la puissance injectée est comprise entre environ 1 jusqu'à 100 W/cm² de surface d'électrode.

8. Procédé selon l'une des revendications précédentes,
**caractérisé en ce que**
la lame d'essuyage (10) est appliquée par un côté de la lèvre d'essuyage (18) contre une plaque d'électrode (76).

9. Procédé selon la revendication 8,
**caractérisé en ce que**
deux lames d'essuyage (10) sont appliquées contre la plaque d'électrode (76) par leurs lèvres d'essuyage (18) tournées l'une vers l'autre.

10. Procédé selon la revendication 9,
**caractérisé en ce que**
deux lames d'essuyage (10) sont reliées par les lèvres d'essuyage (18) tournées l'une vers l'autre par une entretoise (78) au niveau des lèvres que l'on coupe après avoir appliqué le revêtement.

11. Procédé selon l'une des revendications 1 à 7,
**caractérisé en ce que**
la lèvre d'essuyage (18) de la lame d'essuyage (10) est sensiblement perpendiculaire à la plaque d'électrode (56) qui s'étend des deux côtés de la lame d'essuyage (10).

12. Procédé selon la revendication 11,
**caractérisé en ce que**
la plaque d'électrode (56) pénètre latéralement dans des rainures longitudinales (22, 26) de la lame d'essuyage (10).

13. Procédé selon l'une des revendications précédentes,
**caractérisé en ce qu'**
on effectue séquentiellement les étapes de traitement dans différentes chambres de traitement (32, 34, 36, 38, 40).

14. Dispositif pour la mise en oeuvre du procédé selon l'une des revendications précédentes,
**caractérisé en ce que**
les chambres de traitement (32, 34, 36, 38, 40) comportent des buses de gaz (52) dont les ouvertures sont tournées vers les lèvres d'essuyage (18) des lames d'essuyage (10) mises en place,
une ou plusieurs buses de gaz (52) étant associées à une ou plusieurs lames d'essuyage (10), ces lames étant découpées d'une bande profilée à une longueur utilisable (66) pour former des lames d'essuyage, on les installe sur une plaque d'électrode (56) d'un support de pièces (42) et sur les grands côtés des lames d'essuyage (10), on a latéralement des plaques d'électrode (56, 76) avec des fentes de passage de gaz (58), à travers lesquelles le gaz est aspiré par une pompe à gaz (62).

15. Dispositif selon la revendication 14,
**caractérisé par**
des tôles de guidage de gaz (54) installées dans la chambre de traitement (34, 36, 38, 40, 74).

16. Dispositif selon l'une des revendications 14 à 15,
**caractérisé en ce que**
la plaque d'électrode (56, 76) est au moins couverte partiellement par une matière isolante (70).

17. Dispositif selon l'une des revendications 14 à 18,
**caractérisé en ce que**
la plaque d'électrode (56, 76) est prévue pour recevoir plusieurs lames d'essuyage (10).

18. Dispositif selon l'une des revendications 14 à 17,
**caractérisé par**
plusieurs chambres de traitement (32, 34) installées en ligne.

19. Dispositif selon l'une des revendications 14 à 18,
**caractérisé par**
plusieurs chambres de traitement (36, 38, 40) dans une configuration fermée.

20. Dispositif selon l'une des revendications 14 à 19,
**caractérisé en ce que**
les lames d'essuyage (10) et les plaques d'électrode (56) sont installées sur un support de pièces (42) fixé à un moyen de transport (46) pour transporter les lames d'essuyage (10) d'une chambre de traitement à l'autre (36, 38, 40, 74).

21. Dispositif selon la revendication 20,
**caractérisé par**
au moins une chambre de traitement (32, 34) servant également à charger et/ou à décharger des supports de pièces (42).
